# EUROPEAN PATENT APPLICATION

(11) **EP 4 030 236 A1**
(43) Date of publication of application: **20.07.2022**
(21) Application number: 21152071.3
(22) Date of filing: 18.01.2021
(51) Int. Cl.: G03F 7/20, H01L 21/66

(54) **A METHOD OF MONITORING A LITHOGRAPHIC PROCESS AND ASSOCIATED APPARATUSES**

(71) Applicant: ASML Netherlands B.V., 5500 AH Veldhoven (NL)
(72) Inventor: VAN LAARHOVEN, Hendrik Adriaan, 5500 AH Veldhoven (NL); VERMA, Alok, 5500 AH Veldhoven (NL); ANUNCIADO, Roy, 5500 AH Veldhoven (NL); DILLEN, Hermanus Adrianus, 5500 AH Veldhoven (NL); VAN DER SANDEN, Stefan Cornelis Theodorus, 5500 AH Veldhoven (NL)
(74) Representative: ASML Netherlands B.V.

(57) **Abstract**

Disclosed is a method of monitoring a semiconductor manufacturing process. The method comprises obtaining at least one first trained model being operable to derive local performance parameter data from high resolution metrology data, wherein said local performance parameter data describes a local component, or one or more local contributors thereto, of a performance metric and high resolution metrology data relating to at least one substrate having been subject to at least a part of said semiconductor manufacturing process. Local performance parameter data is determined from said high resolution metrology data using said first trained model. The first trained model is operable to determine said local performance parameter data as if it had been subject to an etch step on at least the immediately prior exposed layer, based on said high resolution metrology data comprising only metrology data performed prior to any such etch step.

## Description

### BACKGROUND

### Field of the Invention

0001 The present invention relates to a metrology apparatus and methods usable, for example, to perform metrology in the manufacture of devices by lithographic techniques. The invention further relates to such methods for monitoring edge placement error or a related metric in a lithographic process.

### Background Art

0002 A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

0003 In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

0004 Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

0005 Today's patterning performance is driven by edge placement errors (EPE). The position of the edge of a feature is determined by the features lateral position (Overlay) and the size of the feature (CD). Part of this is very local and stochastic in nature; e.g., dependent on local overlay (LOVL) and local CD uniformity (LCDU). Also, Line Edge Roughness (LER) and line width roughness (LWR) may result in very local CD variations. All of these may be important contributors to the EPE performance. 0006 Currently measurement of these local contributors to EPE may be done using CD-SEM inspection. However, this is too slow for many applications. For some metrics, decapping is required prior to SEM measurement, which is destructive and wasteful and therefore comes at high cost.

0007 It would be desirable to provide an improved method for monitoring EPE and parameters which contribute thereto.

### SUMMARY OF THE INVENTION

0008 The invention in a first aspect provides a method of monitoring a semiconductor manufacturing process, the method comprising: obtaining at least one first trained model being operable to derive local performance parameter data from high resolution metrology data, wherein said local performance parameter data describes a local component, or one or more local contributors thereto, of a performance metric associated with a pattern etched into a layer on a substrate using an etching step of said semiconductor manufacturing process; obtaining high resolution metrology data relating to the pattern prior to said etching step; and determining local performance parameter data from said high resolution metrology data using said first trained model; wherein said local performance parameter and said high resolution metrology data has a spatial resolution higher than global performance parameter data also used in monitoring said semiconductor manufacturing process; wherein said first trained model has been trained on training data comprising first training high resolution metrology data obtained from one or more training substrates prior to said etching step and second training high resolution metrology data obtained from said one or more training substrates subsequent to said etching step.

0009 The invention yet further provides a computer program product comprising machine-readable instructions for causing a processor to perform the method of the first aspect, and associated metrology apparatus and lithographic system.

0010 Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

0011 Embodiments of the invention will now be described, by way of example only, with reference to the accompanying schematic drawings in which corresponding reference symbols indicate corresponding parts, and in which:
Figure 1 depicts a lithographic apparatus;
Figure 2 depicts a lithographic cell or cluster in which an inspection apparatus according to the present invention may be used;
Figure 3 illustrates schematically an inspection apparatus adapted to perform angle-resolved scatterometry and dark-field imaging inspection methods;
Figure 4 is an illustration of (a) an ideal formation of contact holes in two layers; and (b)-(h) various non-ideal formations of contact holes in two layers resultant from respective different issues; and
Figure 5 is a flowchart describing a monitoring method according to an embodiment of the invention.

### DETAILED DESCRIPTION OF EXEMPLARY EMBODIMENTS

0012 Before describing embodiments of the invention in detail, it is instructive to present an example environment in which embodiments of the present invention may be implemented.

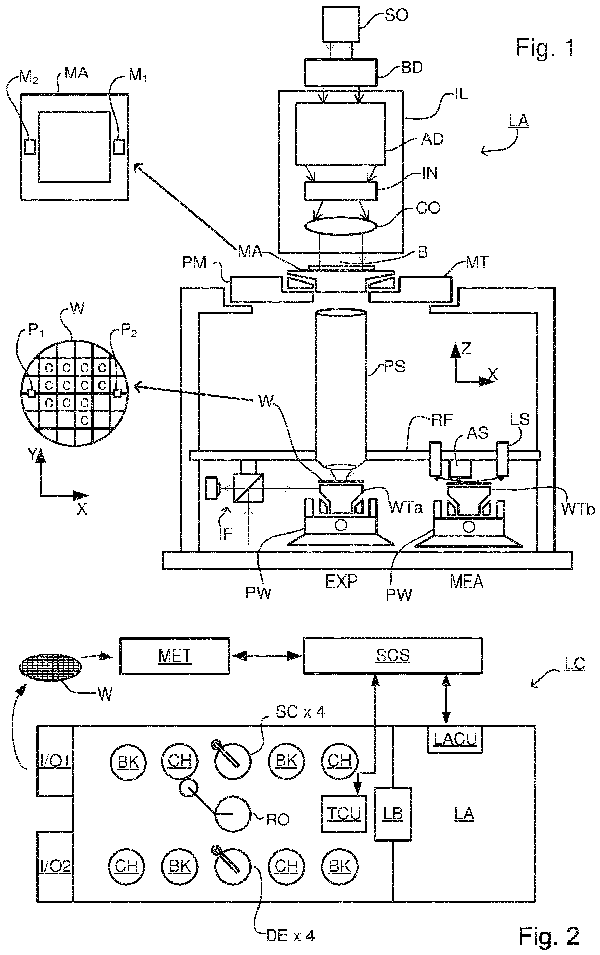

0013 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0014 The illumination system may include various types of optical components, such as refractive, reflective, magnetic, electromagnetic, electrostatic or other types of optical components, or any combination thereof, for directing, shaping, or controlling radiation.

0015 The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

0016 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0017 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0018 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0019 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0020 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0021 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0022 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

0023 Patterning device (e.g., reticle/mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

0024 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

0025 Combinations and/or variations on the above described modes of use or entirely different modes of use may also be employed.

0026 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0027 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0028 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0029 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

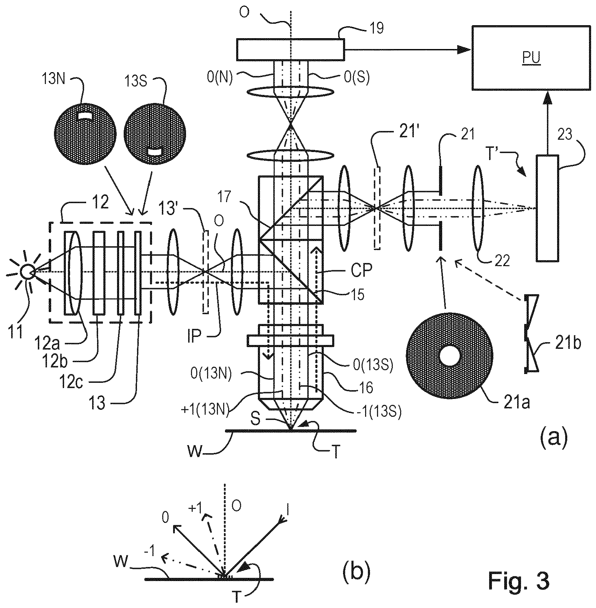

0030 A metrology apparatus suitable for use in embodiments of the invention is shown in Figure 3(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

0031 As shown in Figure 3(b), target structure T is placed with substrate W normal to the optical axis O of objective lens 16. The substrate W may be supported by a support (not shown). A ray of measurement radiation I impinging on target structure T from an angle off the axis O gives rise to a zeroth order ray (solid line 0) and two first order rays (dot-chain line +1 and double dot-chain line -1), hereafter referred to as a pair of complementary diffraction orders. It should be noted that the pair of complementary diffraction orders may be any higher order pair; e.g., the +2, -2 pair etc. and is not limited to the first order complementary pair. It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

0032 At least the 0 and +1 orders diffracted by the target structure T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

0033 A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

0034 In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

0035 Position errors may occur due to an overlay error (often referred to as "overlay"). The overlay is the error in placing a first feature during a first exposure relative to a second feature during a second exposure. The lithographic apparatus minimizes the overlay errors by aligning each substrate accurately to a reference prior to patterning. This is done by measuring positions of alignment marks on the substrate using an alignment sensor. More information on the alignment procedure can be found in U.S.

Patent Application Publication No. US 2010-0214550, which is incorporated herein in its entirety by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus aims to minimize these focal positon errors by measuring the substrate surface topography prior to patterning using a level sensor. Substrate height corrections are applied during subsequent patterning to help assure correct imaging (focusing) of the patterning device onto the substrate. More information on the level sensor system can be found in U.S. Patent Application Publication No. US 2007-0085991, which is incorporated herein in its entirety by reference.

0036 Besides the lithographic apparatus LA and the metrology apparatus MT, one or more other processing apparatuses may be used during device production as well. An etching station (not shown) processes the substrates after exposure of the pattern into the resist. The etch station transfers the pattern from the resist into one or more layers underlying the resist layer. Typically etching is based on application of a plasma medium. One or more local etching characteristics may e.g. be controlled using temperature control of the substrate or directing the plasma medium using a voltage controlled ring. More information on etching control can be found in PCT Patent Application Publication No. WO 2011-081645 and U.S. Patent Application Publication No. US 2006-016561, which are incorporated herein in their entireties by reference.

0037 During the manufacturing of devices, it is desired that the process conditions for processing substrates using one or more processing apparatuses such as the lithographic apparatus or etching station remain stable such that properties of the features remain within certain control limits. Stability of the process is of particular significance for features of the functional parts of an electric device such as an IC, also referred to as product features. To help ensure stable processing, process control capabilities should be in place. Process control involves monitoring of processing data and implementation of means for process correction, e.g. control a processing apparatus based on one or more characteristics of the processing data. Process control may be based on periodic measurement by the metrology apparatus MT, often referred to as "Advanced Process Control" (further also referenced to as APC). More information on APC can be found in U.S. Patent Application Publication No. US 2012-008127, which is incorporated herein in its entirety by reference. A typical APC implementation involves periodic measurements on metrology features on the substrates to monitor and correct drifts associated with one or more processing apparatuses. The metrology features reflect the response to process variations of the product features. The sensitivity of the metrology features to process variations may be different compared to the sensitivity to the product features. In that case, a so-called "Metrology To Device" offset (also referenced to as MTD) may be determined. One reason for this is MTD offset is that the actual product structures are often much (orders of magnitude) smaller than the size of the target structures which are required for scatterometry or imaging measurements, and this difference in size can result in different parameter behavior (e.g., pattern placement and resulting overlay for metrology targets may differ from pattern placement and resulting overlay of actual structures). To mimic the behavior of product features, features within the metrology targets may be made smaller (e.g., of comparable size to the product structures, which can be referred to as at-resolution overlay ARO), incorporate segmented features, assist features or features with a particular geometry and/or dimension. A carefully designed metrology target ideally should respond in a similar fashion to process variations as do the product features. More information on metrology target design can be found in PCT Patent Application Publication No. WO 2015-101458 which is incorporated herein in its entirety by reference. 0038 In another approach, metrology may be performed directly on the product structure. This can be done using a scanning electron microscope (SEM) or an e-beam metrology apparatus for example. However, these devices are typically too slow for process control in a commercial (high-volume manufacturing HVM) environment. Another alternative, referred to as in-device metrology IDM, may comprise using a scatterometer based metrology apparatus to measure the product structure (e.g., which has sufficient regularization) directly. Such product structure may have sufficient regularization such that it can act as an effective diffraction grating. Modern scatterometry tools such as illustrated in Figure 3 have the capability of measuring (at least) an asymmetry based metric (e.g., overlay) on such small structures.

0039 Both global parameters and local parameters contribute to the edge placement error (EPE) budget. Global parameters may include, for example, one or more of: global overlay, global critical dimension (CD), global tilt and global contact area (CA)/global EPE between structures in successive layers, critical dimension uniformity (CDU), line width roughness (LWR), or line edge roughness (LER). Local parameters may include one or more of: local CD, local overlay (LOVL), local CA/local EPE, local tilt, local side wall angle (SWA), local line placement. The local parameters in particular manifest at spatial scales which are too small to measure using some relatively fast metrology tools such as scatterometers (e.g., those which typically integrate signals across an area (spot size) larger than said spatial scale of variation, and are therefore presently monitored using SEMs (e.g., e-beam tools) or similar tools. Local parameter data may relate to spatial scales at which critical dimension or overlay variations occur. Such a spatial scale may be less than 150µm, less than 100µm, less than 70µm or less than 50µm for example. The spatial scale may less than 15 times, 10 times, 8 tines or 5 times the size of a pitch of product structures on said substrate, to which the high resolution metrology data (used to derive the local parameter data) relates.

0040 The multiple different global and local parameters which lead to EPE are measured/estimated independently and combined towards an EPE metric. Since each of the components is measured independently, the sensitivity, scaling and other metrology issues corresponding to each parameter add up to a large error in total EPE estimation. Combining each term into the EPE metric is layer specific and non-trivial. Having to measure each component independently calls for a separate metrology solution.

0041 Disclosed herein, it is proposed to divide the EPE budget into a global term and local term, instead of measuring individual parameters which contribute to the EPE budget. The global term may be directly measured while the local term may be estimated using a model trained *a priori.* The terms, once measured /estimated, can be combined to calculate EPE. In an embodiment, the global term may be measured using an optical metrology device (e.g., scatterometer) instead of using an SEM.

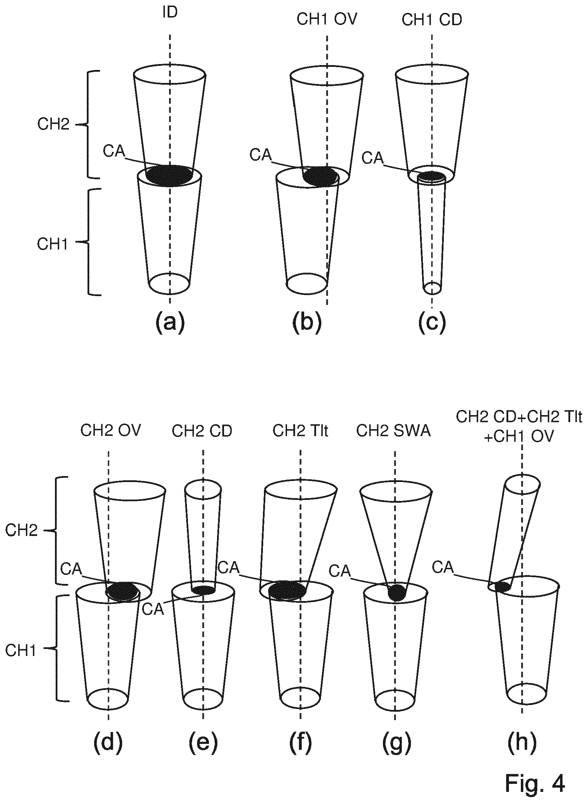

0042 Figure 4 illustrates a specific example case where the relevant higher level metric is the contact area CA between features (or contact holes) in two adjacent layers CH1, CH2. Any higher level metric (e.g., an EPE related metric) which comprises both local and global contributions can be considered. This CA metric can be considered to be an (e.g., 2D) EPE or EPE-related metric. Both local and global effects/parameters influence the CA; for example: local and global overlay X/Y, local and global CD X/Y, local and global tilt.

0043 For many processes, such as the process illustrated (aligning of contact hole layers), the CA or EPE (which may be considered a proxy for yield) can only presently be measured using an SEM after decapping. The disadvantage with decapping is that this is typically a destructive process; e.g., to perform the SEM measurement, the devices under inspection will become waste (expensive). Even if the CA/EPE could be measured without decapping, SEM measurements are too slow for frequent measurement.

0044 Figure 4(a) shows the ideal ID case, where the contact area CA between the contact hole structure of the lower layer CH1 and the contact hole structure of the upper layer CH2 is maximized. This is a result of optimized local and global performance parameters such as local and global overlay , local and global CD, local and global tilt Tlt and local and global side wall angle SWA. Figure 4(b) shows an example where the CA is impacted by overlay OV relating to the lower layer CH1. Figure 4(c) shows an example where the CA is impacted by CD relating to the lower layer CH1. Figure 4(d) shows an example where the CA is impacted by overlay relating to the upper layer CH2. Figure 4(e) shows an example where the CA is impacted by CD relating to the upper layer CH2. Figure 4(f) shows an example where the CA is impacted by tilt relating to the upper layer CH2. Figure 4(g) shows an example where the CA is impacted by too large SWA relating to the upper layer CH2. Figure 4(h) illustrates the result of a combination of effects in the two layers; it shows an example where the CA is impacted by CD and tilt relating to the upper layer CH2 and overlay OV relating to the lower layer CH1. When the impact of one or more of these performance parameters being out of specification results in a contact area of zero (no contact) or too small for a good connection, then the device will be defective and will not yield.

0045 It is proposed to develop a methodology wherein a performance metric or high level metric indicative of yield such as EPE and/or a related metric such as CA can be inferred from non-destructive measurements only during production. Such a method may use one or more models (e.g., machine learned models such as trained neural networks) which are trained in a calibration phase. It is proposed that data from destructive (decap) metrology is used only for the training of the models. The method comprises considering global performance parameter(s) (e.g., a global component of the high level metric or global contributors thereto) separately from the local performance parameter(s) (e.g., a local component of the high level metric or contributor local performance parameters to the high level metric). The global component may be monitored via regular optical metrology (e.g., scatterometry metrology). The local component may be monitored (e.g., less frequently) via non-destructive e-beam or SEM measurements. Respective models may be used to determine the global component and the local component from the metrology data. The output of the models may then be combined to determine the high level metric.

0046 The method may comprise training a first model or local model to infer from non-destructive metrology (e.g., e-beam metrology), local (e.g., EPE) performance parameter data e.g., which relates to one or more performance parameters measurable only from destructive metrology. Such a model may be trained to predict local after-etch inspection (AEI) data relating to a structure after etching of the top layer from after-develop inspection (ADI) metrology data and (optionally) AEI metrology data relating to one or more lower layers only. In other words, the local model may be trained to predict local metrology data, such as might be resultant from decap SEM metrology, based on non-destructive (e.g., e-beam ADI) metrology. Alternatively, or in addition, the first model may also be trained to infer local performance parameter data from optical metrology data such as scatterometry data (for example where the scatterometer has a measurement spot sufficiently small to measure at the spatial scale required for resolving local parameters). Again, the scatterometry data may comprise "pupils", i.e., a representation (e.g., as captured by a camera) of the pupil plane of radiation scattered from the measured structure, i.e., angularly resolved spectra.

0047 Optionally, the method may comprise obtaining or training a second model or global model to infer global performance parameter data relating to one or more global parameters from optical metrology data such as scatterometry data. For example the scatterometry data may comprise "pupils", i.e., a representation (e.g., as captured by a camera) of the pupil plane of radiation scattered from the measured structure, i.e., angularly resolved spectra. The second model may be a physics based model or machine learned (trained) model, for example.

0048 During production, the first trained model may be used to infer local performance parameter data from first (high resolution) metrology (e.g., e-beam based, such as SEM metrology) data, while the second model may be used to infer global performance parameter data from second metrology data; e.g., optical metrology data such as scatterometer metrology pupils. The outputs of the first and second models may then be combined to infer the high level metric (e.g., EPE, CA) and/or predicted yield. It should be noted that the scatterometry metrology will typically be performed more frequently than the local metrology, and can be combined with the most recent local metrology data or local performance parameter data inferred therefrom.

0049 The first metrology data and/or high resolution metrology data comprises a spatial resolution higher than global performance parameter data also used in monitoring said semiconductor manufacturing process. As such, the high resolution metrology data may comprise a spatial resolution the same or similar to that of the local parameter. For example the high resolution metrology data may relate to spatial scales at which critical dimension or overlay variations occur. Such a spatial scale may be less than 150µm, less than 100µm, less than 70µm or less than 50µm for example. The spatial scale may less than 15 times, 10 times, 8 tines or 5 times the size of a pitch of product structures on said substrate, to which the high resolution metrology data relates.

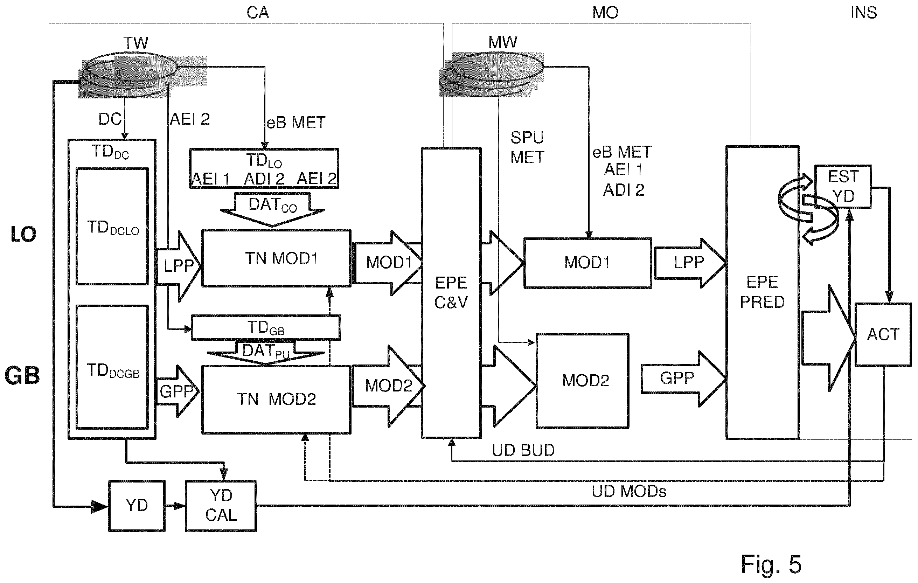

0050 Figure 5 is a flowchart showing an exemplary method divided into a calibration phase CA, a monitoring phase MO and a guided inspection phase INS. The flow is separated into a local flow LO (top half) and global flow GB (bottom half). The specific process described relates to a two-layer process such as illustrated in Figure 4, although the concepts may be extended to more complex or different processes.

0051 Referring to the calibration phase, this may comprise the step of training of the first (local) model TN MOD 1 and the step of training of the second (global) model TN MOD2. Training wafers TW are decapped DC and measured to obtain decap training data TD_{DC}, which may be divided into local decap training data TD_{DCLO} and global decap training data TD_{DCGB}.

0052 To train the first model, the training wafers TW may also be measured to obtain local training data TD_{LO}, such as after-etch inspection AEI data AEI1, AEI2 following etching/processing respectively of layers 1 and 2. The local training data TD_{LO} may also comprise after develop (i.e., pre-etch or in-resist) inspection metrology data ADI2 from layer 2. This ADI2 measurement data makes it possible to predict parameters such as CD and SWA following the second etch and therefore predict the structure at the interface; this is not possible from the AEI2 measurement alone where, for example, the respective layer is several µm thick (which is typically the case). The local training data TD_{LO} may be obtained from (e.g., non-destructive) e-beam (SEM) metrology on the training wafers. In an embodiment, the local training data TD_{LO} may comprise contour data DATco or related local performance parameters (e.g., one or more of CD, CDU, line edge roughness, line width roughness etc.).

0053 The training data may also comprise global training data TD_{GB} measured from the training wafers. This global training data TD_{GB} may comprise pupil data DAT_{PU}, for example as measured using a scatterometer, e.g., using in-device metrology IDM techniques (measurement of on-product IDM targets, for example in scribe lanes). The global training data TD_{GB} may also comprise other scatterometer derived data (e.g., AEI, or more specifically AEI2 scatterometer data or IDM data) such as one or more of AEI overlay data, AEI CD data, AEI tilt data or AEI CA data. Optionally global training data TD_{GB} may comprise scatterometry (e.g., IDM) ADI overlay data.

0054 The step of training the first model TN MOD1 may comprise training the model using the local decap training data TD_{DCLO} and/or local performance parameter data LPP determined therefrom and the local training data TD_{LO} or contour data DATco, such that the model MODI, when trained, can infer the local performance parameter data LPP from local training or metrology data TD_{LO}/contour data DATco e.g., as measured non-destructively using an e-beam tool (such as a SEM) or any other suitable metrology tool able to measure local parameters. The local performance parameter data LPP and/or local decap training data TD_{DCLO} may comprise one or more of: contour data, local CD, local CDU, line placement error (LPE), local tilt, local overlay, and local contact area overlap (local CA).

0055 In an embodiment, the trained first model may be trained to directly predict local CA (or other high level or EPE metric), or else it may be trained to predict at least some of the other local performance parameters which contribute to CA (or other EPE metric) such that CA/EPE/yield can then be predicted in a subsequent step.

0056 The step of training the second model TN MOD2 may comprise training the model using the global decap training data TD_{DCGB} and/or global performance parameter data GPP determined therefrom and the global training data TD_{GB} or pupil data DAT_{PU}, such that the model, when trained, can infer the global performance parameter data GPP from global training or metrology data TD_{GB}/ pupil data DAT_{PU}. The global performance parameter data GPP/ global decap training data TD_{DCGB} may comprise one or more of: global overlay data, global EPE data, global CA data, global tilt and global CD and/or CDU data. This second model MOD2, when trained, may comprise a pupil mapping model or a metrology recipe profile which can map measured pupils to global performance parameter data GPP; e.g., the global component of the EPE (or CA). For example, the training may output a direct CA or EPE profile which directly provides CA or EPE values based on measured pupil data. Alternatively or in addition, this training may output one or more of a metrology recipe profile for one or more of global overlay, tilt and CD.

0057 The output of the first and second models may be used in a step EPE C&V of creating and validating an EPE budget for a production process.

0058 In a monitoring phase MO, one or more monitoring wafers may be measured. The monitoring wafers MW may comprise actual product wafers as manufactured in a production setting (e.g., high volume manufacturing HVM setting). During this monitoring phase, regularly metrology eB MET (e.g., non-destructive e-beam (SEM) metrology), such as AEI1 and ADI2 (and/or AEI2) metrology is fed to the first trained model MOD1 to infer the local performance parameter data LPP and therefore the local EPE/CA component. Local terms will not be measured as frequently as global terms, so for the total EPE (CA) reconstruction, temporarily stored local performance parameter data may be retrieved to be combined with the newer global performance parameter data. The local performance parameter data may de described in terms of the high level parameters (i.e., the local EPE or CA component), and/or contributors thereto (e.g., one or more of local CD, local overlay, local tilt, local SWA etc.).

0059 During the monitoring phase, frequent scatterometry measurements (e.g., IDM measurements) may be performed on the monitoring wafers, to obtain second metrology data SPU MET (e.g., scatterometer pupil data/angularly resolved spectra from radiation scattered from structures on the wafers and optionally additional scatterometer data). This second metrology data can then be fed into the one or more second trained models MOD2 to output the global performance parameter data GPP and therefore the global EPE/CA component. The global performance parameter data GPP may de described in terms of the high level parameters (i.e., the global EPE or CA component), and/or contributors thereto (e.g., one or more of global CD, global CDU, global overlay, global tilt, global SWA etc.).

0060 The local performance parameter data LPP and global performance parameter data GPP can then be combined in a prediction step EPE PRED to predict EPE or CA or other high level metric indicative of yield. Based on the this prediction, yield may be predicted EST YD and an action performed ACT. Where this final phase is a guided inspection phase INS, the action may comprise performing a guided inspection. For example, areas predicted to have low yield may be subjected to a guided inspection comprising destructive decap SEM or e-beam metrology. Based on the guided inspection result, one or both of the first model (local prediction model) and second model (IDM recipe profile(s)) may be adjusted, updated or further trained UD MODs. Alternatively or in addition, the guided inspection result may be used to update the EPE budget UD BUD and/or update the manner that the local and global terms are combined to arrive at total EPE / CA.

0061 The step of estimating yield EST YD based on the predicted EPE / CA may be based on a previously established relationship between e.g., decap e-beam/SEM data and actually measured yield. Such a relationship may be established as part of a yield calibration step YD CAL where the relationship is determined (or additional model trained) based on measured yield YD from the training wafers and the decap training data TD_{DC}.

0062 In summary, the proposed method provides a simpler estimation of EPE or a related metric which (in some embodiments) does not require breakdown into contributor parameters (e.g., overlay/CD etc.) other than into local and global components. The proposed breakdown can be layer agnostic. The method enables (likely) problem areas to be identified (e.g., locations where the combination of global and local terms leads to high probability of failure) without the need for destructive metrology (e.g., other than to verify the prediction and/or in the initial calibration). These problem areas, when identified, can be inspected using slow but very high resolution e-beam, thereby enabling the optimal usage of available e-beam capacity.

0063 The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

0064 The term "lens", where the context allows, may refer to any one or combination of various types of optical components, including refractive, reflective, magnetic, electromagnetic and electrostatic optical components.

0065 The term target should not be construed to mean only dedicated targets formed for the specific purpose of metrology. The term target should be understood to encompass other structures, including product structures, which have properties suitable for metrology applications.

0066 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

0067 Further embodiments are disclosed in the list of numbered clauses below:
1. A method of monitoring a semiconductor manufacturing process, the method comprising:
   obtaining at least one first trained model being operable to derive local performance parameter data from high resolution metrology data, wherein said local performance parameter data describes a local component, or one or more local contributors thereto, of a performance metric associated with a pattern etched into a layer on a substrate using an etching step of said semiconductor manufacturing process;
   obtaining high resolution metrology data relating to the pattern prior to said etching step; and
   determining local performance parameter data from said high resolution metrology data using said first trained model; wherein said local performance parameter and said high resolution metrology data has a spatial resolution higher than global performance parameter data also used in monitoring said semiconductor manufacturing process; and wherein said first trained model has been trained on training data comprising first training high resolution metrology data obtained from one or more training substrates prior to said etching step and second training high resolution metrology data obtained from said one or more training substrates subsequent to said etching step.
2. A method according to clause 1, wherein said local performance parameter data and/or said high resolution metrology data relates to a spatial scale of less than 100µm.
3. A method according to clause 1, wherein said local performance parameter data and/or said high resolution metrology data relates to a spatial scale of less than 50µm.
4. A method according to clause 1, 2 or 3, wherein said local performance parameter data and/or said high resolution metrology data relates to a spatial scale of less than 10 times the size of a pitch of product structures on said substrate, to which said high resolution metrology data relates.
5. A method according to any preceding clause, wherein said performance metric is a metric indicative of yield for the lithographic process.
6. A method according to any preceding clause, wherein said high resolution metrology data comprises data which has been obtained using non-destructive metrology.
7. A method according to any preceding clause, wherein said high resolution metrology data comprises scatterometer data relating to radiation scattered by structures formed by said lithographic process on one or more substrates.
8. A method according to clause 7, wherein said scatterometer data comprises angularly resolved spectra from radiation scattered by said structures.
9. A method according to any preceding clause, wherein said high resolution metrology data comprises e-beam metrology data such as scanning electron microscope metrology data.
10. A method according to any preceding clause, wherein said high resolution metrology data comprises contour data relating to a contour of one or more features or structure formed by said lithographic process.
11. A method according to any preceding clause, wherein said at least one first trained model is trained such that said local performance parameter data comprises data directly describing said local component of the of the performance metric.
12. A method according to any of clauses 1 to 10, wherein said at least one first trained model is trained such that said local performance parameter data comprises local contributor performance parameter data.
13. A method according to clause 12, wherein said local contributor performance parameter data is described in terms of one or more of: local critical dimension, local overlay, local tilt of any structure or feature formed by said lithographic process, local side wall angle of any structure or feature formed by said lithographic process, local line placement.
14. A method according to any preceding clause wherein said performance metric comprises edge placement error and/or contact area between two structures formed by the lithographic process.
15. A method according to any preceding clause, wherein said local performance parameter data comprises at least some metrology data which could only be directly measured by a destructive metrology technique.
16. A method according to any preceding clause, comprising determining said performance metric from a combination of said local performance parameter data and said global performance parameter data.
17. A method according to clause 16, comprising: obtaining second metrology data; obtaining at least one second model being operable to derive said global performance parameter data from second metrology data, wherein said global performance parameter data describes a global component, or one or more global contributors thereto, of said performance metric indicative of yield; and using said at least one second model to determine said global performance parameter data from said second metrology data.
18. A method according to clause 17, wherein said at least one second model is trained such that said global performance parameter data comprises data directly describing said global component of the of the performance metric.
19. A method according to clause 17, wherein said at least one second trained model is trained such that said global performance parameter data comprises global contributor performance parameter data.
20. A method according to clause 19, wherein said global contributor performance parameter data is described in terms of one or more of: global critical dimension, global overlay, global tilt of any structure or feature formed by said lithographic process, global side wall angle of any structure or feature formed by said lithographic process, critical dimension uniformity, line edge roughness.
21. A method according to any of clauses 17 to 20, wherein said second metrology data has been obtained using non-destructive metrology.
22. A method according to any of clauses 17 to 21, wherein said second metrology data comprises metrology data measured using an optical metrology tool.
23. A method according to any of clauses 17 to 22, wherein said second metrology data comprises scatterometer data relating to radiation scattered by structures formed by said lithographic process on one or more substrates.
24. A method according to clause 23, wherein said second metrology data comprises angularly resolved spectra from radiation scattered by said structures.
25. A method according to any of clauses 17 to 24, comprising the step of training said second model using training data comprising destructive metrology data obtained from destructive metrology relevant for said global component and corresponding second training data.
26. A method according to clause 25, wherein said second training data comprises training scatterometer data relating to the same training substrates as said destructive metrology data relates.
27. A method according to clause 26, wherein the training scatterometer data comprises angularly resolved spectra from radiation scattered by structures on said training substrates.
28. A method according to any of clauses 16 to 27, comprising obtaining a relationship between said performance metric and yield; and determining yield for the lithographic process based on said determined performance metric and said relationship.
29. A method according to clause 28, comprising determining said relationship in a calibration based on training yield data and corresponding training data relating to said determined performance metric.
30. A method according to any of clauses 16 to 29, comprising performing an action based on said determined performance metric.
31. A method according to clause 30, wherein the action comprises performing a guided inspection on an area identified as having a determined performance metric indicative of poor performance and/or a defect.
32. A method according to clause 31, wherein the result of said guided inspection is used in an update step to update at least said first trained model.
33. A method according to clause 32, wherein the result of said guided inspection is used to update an edge placement error budget and/or update how said local component and global component are combined to determine said performance metric.
34. A method according to any preceding clause wherein said second training high resolution metrology data comprises destructive metrology data obtained from destructive metrology.
35. A method according to clause 34, comprising training said first trained model using said second training high resolution data relevant for said local component and corresponding said first training high resolution data.
36. A method according to clause 35, wherein said first high resolution training data comprises training e-beam metrology data or training scanning electron microscope data relating to the same training substrates as said second training high resolution metrology data relates.
37. A method according to clause 36, wherein said first training high resolution metrology data comprises contour data relating to a contour of one or more features or structures formed on said training substrates.
38. A computer program comprising processor readable instructions which, when run on suitable processor controlled apparatus, cause the processor controlled apparatus to perform the method of any of clauses 1 to 37.
39. A computer program carrier comprising the computer program of clause 38.
40. A processing apparatus comprising: a processor; and a computer program carrier comprising the computer program of clause 38.
41. A metrology apparatus comprising the processing apparatus of clause 40.
42. A lithographic exposure apparatus comprising the processing apparatus of clause 38.

0068 The breadth and scope of the present invention should not be limited by any of the above-described exemplary embodiments, but should be defined only in accordance with the following claims and their equivalents.

## Claims

1. A method of monitoring a semiconductor manufacturing process, the method comprising:
obtaining at least one first trained model being operable to derive local performance parameter data from high resolution metrology data, wherein said local performance parameter data describes a local component, or one or more local contributors thereto, of a performance metric associated with a pattern etched into a layer on a substrate using an etching step of said semiconductor manufacturing process;
obtaining high resolution metrology data relating to the pattern prior to said etching step; and
determining local performance parameter data from said high resolution metrology data using said first trained model, wherein said local performance parameter and said high resolution metrology data have a spatial resolution higher than global performance parameter data used in monitoring said semiconductor manufacturing process, and wherein said first trained model has been trained on training data comprising first training high resolution metrology data obtained from one or more training substrates prior to said etching step and second training high resolution metrology data obtained from said one or more training substrates subsequent to said etching step.

2. A method as claimed in claim 1, wherein said local performance parameter data and/or said high resolution metrology data relates to process variations at a spatial scale of less than 100µm.

3. A method as claimed in claim 1 or 2, wherein said local performance parameter data and/or said high resolution metrology data relates to process variations at a spatial scale of less than 10 times the size of a pitch of product structures on said substrate, to which said high resolution metrology data relates.

4. A method as claimed in any preceding claim, wherein said performance metric is a metric indicative of yield for the lithographic process.

5. A method as claimed in any preceding claim, wherein said high resolution metrology data comprises data which has been obtained using non-destructive metrology.

6. A method as claimed in any preceding claim, wherein said high resolution metrology data comprises e-beam metrology data such as scanning electron microscope metrology data.

7. A method as claimed in any preceding claim, wherein said at least one first trained model is trained such that said local performance parameter data comprises local contributor performance parameter data.

8. A method as claimed in claim 7, wherein said local contributor performance parameter data is described in terms of one or more of: local critical dimension, local overlay, local tilt of any structure or feature formed by said lithographic process, local side wall angle of any structure or feature formed by said lithographic process, local line placement.

9. A method as claimed in any preceding claim wherein said performance metric comprises edge placement error and/or contact area between two structures formed by the lithographic process.

10. A method as claimed in any preceding claim, wherein said local performance parameter data comprises at least some metrology data which could only be directly measured by a destructive metrology technique.

11. A method as claimed in any preceding claim, comprising:
determining said performance metric from a combination of said local performance parameter data and said global performance parameter data.

12. A method as claimed in claim 11, further comprising
obtaining second metrology data;
obtaining at least one second model being operable to derive said global performance parameter data from second metrology data, wherein said global performance parameter data describes a global component, or one or more global contributors thereto, of said performance metric indicative of yield; and
using said at least one second model to determine said global performance parameter data from said second metrology data.

13. A method as claimed in claim 12, wherein said second metrology data comprises metrology data measured using an optical metrology tool.

14. A method as claimed in any of claims 11 to 13, further comprising performing inspection on an area of the substrate identified as having a determined performance metric indicative of poor performance and/or a defect.

15. A method as claimed in claim 14, wherein the result of said inspection is used to update at least said first trained model.
